# EUROPÄISCHE PATENTSCHRIFT

(11) **EP 2 122 376 B1**
(45) Veröffentlichungstag und Bekanntmachung des Hinweises auf die Patenterteilung: **25.08.2010**
(21) Anmeldenummer: 08707066.0
(22) Anmeldetag: 16.01.2008
(51) Int. Cl.: G01R 31/28

(54) **KONTAKTIERSTATION ZUM TESTEN VON PRÜFLINGEN UNTER TEMPERATUR**
CONTACTING STATION FOR TESTING TEST SAMPLES UNDER THERMAL CONDITIONS
POSTE DE CONTACT POUR TESTER DES ÉCHANTILLONS SOUS CONDITIONS THERMIQUES

(30) Priorität: 15.02.2007 DE 102007007528
(43) Veröffentlichungstag der Anmeldung: 25.11.2009
(73) Patentinhaber: Hatec Handhabungstechnik Maschinenbau Gmbh, 83052 Bruckmühl (DE)
(72) Erfinder: LINNERBAUER, Horst-Dieter, 83052 Bruckmühl (DE)
(74) Vertreter: Flach, Dieter Rolf Paul
(86) Internationale Anmeldenummer: PCT/EP2008/000297
(87) Internationale Veröffentlichungsnummer: WO 2008/098655

(56) Entgegenhaltungen:
- DE-A1- 4 031 793
- US-A- 3 408 565
- US-A- 5 516 028
- US-A- 6 104 183

## Beschreibung

Die Erfindung betrifft eine Kontaktierstation zum Testen von Prüflingen unter Temperatur nach dem Oberbegriff des Anspruches 1. DE 4031793 offenbart eine solche Vorrichtung.

Elektronische Baukomponenten oder Baugruppen, die nachfolgend teilweise auch als Prüflinge oder Hybriden bezeichnet werden, müssen je nach Anforderung unterschiedlichen Tests unterzogen werden. Diese Tests dienen grundsätzlich zunächst einmal zur Überprüfung der elektrischen und elektronischen Funktionstüchtigkeit der zu überprüfenden Prüflinge oder Hybriden.

In vielen Fällen muss aber nicht nur die elektronische Funktionstüchtigkeit bei einer normalen Umgebungstemperatur überprüft werden, sondern auch unter Extremstbedingungen bzw. auch unter Extremtemperaturen, beispielsweise bei bis zu über 100°C, sowie andererseits bis zu weit unter 0°C, beispielsweise mehr als -30°C oder mehr als -40°C.

Andererseits soll im Hinblick auf die unterschiedlichsten Baugruppen und die immer schneller zum Zuge kommenden neuen Techniken das Testsystem so aufgebaut sein, dass es den Bedürfnissen nach Flexibilität zum einen und hoher Prüfqualität zum anderen Rechnung trägt.

Bekannt geworden sind beispielsweise stationäre Prüfanlagen mit einer Kammer mit frontseitiger Öffnung, in der ein Werkstückträger mit dem darauf befindlichen Prüfling oder Hybrid in das Kammerinnere gebracht werden kann. Nach Schließen der Kammer wird die Kammer dann beispielsweise auf die gewünschte Temperatur von beispielsweise 100°C oder 150°C erhitzt oder beispielsweise auf -40°C gekühlt, um dann die entsprechenden Prüf- und Testläufe durchzuführen.

Dazu werden in der Regel eine Vielzahl von Kontaktstiften auf einem Kontaktstiftträger verwendet, der bei verschlossener Kammer auf den Hybrid herabbewegt wird, um an den vorher festgelegten Kontakt- und/oder Lötstellen die Prüfmessungen durchzuführen.

Anschließend wird die Kammer wieder geöffnet, der Hybrid in der Regel vollautomatisch herausgefahren und ein nächster zu überprüfender Prüfling hineingeführt.

Aufgabe der vorliegenden Erfindung ist es, ausgehend von diesem bekannten Stand der Technik eine verbesserte Testvorrichtung zu schaffen.

Die Aufgabe wird erfindungsgemäß entsprechend den im Anspruch 1 angegebenen Merkmalen gelöst. Vorteilhafte Ausgestaltungen der Erfindung sind in den Unteransprüchen angegeben.

Zum Stand der Technik abweichend wird nunmehr ein anderes Grundkonzept für eine Testvorrichtung von Prüflingen und Hybriden vorgeschlagen.

Erfindungsgemäß ist vorgesehen, dass das Nadelfeld für eine Kontaktierstation zum Testen und Durchmessen eines Prüflings oder Hybrids Kontakt- oder Messnadeln umfasst, die in Längsrichtung dieser Kontakt- oder Messnadeln zumindest zweigeteilt sind. Erfindungsgemäß umfassen die in einem Nadelfeld verwendeten Nadeln sogenannte dem Prüfling oder Hybrid näherliegende Transfernadeln, an die sich gegenüberliegend zum Prüfling oder Hybrid (also an der rückwärtigen Seite der Transfernadeln) sogenannte Kontaktstifte anschließen. Dabei sind sowohl die Kontaktstifte als die sich daran anschließenden Transfernadeln über jeweils einen Nadelträger gehalten und/oder geführt.

Durch dieses Prinzip lassen sich jedoch entscheidungserhebliche Vorteile gegenüber herkömmlichen Lösungen realisieren.

Durch diesen Aufbau ist nämlich sichergestellt, dass die Transfernadeln (und das heißt lediglich die Transfernadeln) von der Kammerinnenseite her temperiert werden. Da ein Prüfling z.B. bei entsprechend hohen Temperaturen (beispielsweise von 150°C) oder bei niedrigen Temperaturen (beispielsweise von 40°C) vermessen werden muss, bedeutet dies, dass nur die Transfernadeln ins Kammerinnere in Richtung Prüfling vorstehen und hier entsprechend den im Kammerinneren herrschenden Temperaturen temperiert werden. Im Ruhezustand (also wenn nicht gemessen wird) können dabei die rückwärtigen Kontaktstifte soweit verstellt oder zurückgezogen werden, dass sie mit den Transfernadeln nicht mehr in Kontakt stehen. Von daher ist im Gegensatz zum Stand der Technik bezüglich der dort verwendeten durchgängigen Nadeln sichergestellt, dass über die Transferstifte keine Temperaturbrücken zur rückwärtigen Messverdrahtung (also am Ende der Kontaktstifte) erzeugt wird. Denn hierüber könnten sehr hohe Temperaturen oder sehr niedrige Temperaturen bis zur rückwärtigen Messverdrahtung gelangen, wenn wie beim Stand der Technik eine durchgängige, also permanente Temperaturbrücke vom Kammerinnenraum zum rückwärtigen Messbereich der Kontaktierstation bestehen würde. Die unerwünschte Temperaturbrücke im Stand der Technik ist vor allem auch dadurch verursacht worden, dass die Messnadeln aus elektrisch leitfähigem Material bestehen müssen, da hierüber Ströme fließen, um den Prüfling auf seine Funktionstauglichkeit zu überprüfen.

In einer bevorzugten Ausführungsform der Erfindung ist es dabei ferner möglich, den Raum zwischen den Kontaktstiften und den sich daran anschließenden Transfernadeln beispielsweise mit einem trockenen Gas, insbesondere Trockenluft, zu durchspülen und damit eine Betauung zu verhindern. Dies ist besonders wichtig bei Temperaturmessungen im Frostbereich von beispielsweise -30°C bis -50°C und mehr.

Ferner kann die Nadelführung für die Transferstifte auch noch eine Isolierung mit umfassen, wodurch eine weitere Abschottung des Messbereichs von dem im Kammerinneren herrschenden Temperaturbereich ermöglicht.

Bevorzugt ist der Aufbau derart, dass eine stationäre Nadelführung für die Transfernadeln verwendet wird. Dabei kann die Nadelführung für die Transfernadeln auch noch eine zu dem Prüfling entfernt liegende Mitnehmerplatte umfassen, die die Transfernadeln festhält und gegebenenfalls nur geringe axiale Verstellwege der Transfernadeln gegenüber dieser Mitnehmerplatte erlaubt, beispielsweise unter Überwindung einer entsprechenden Reibverbindung.

Als besonders günstig hat sich ferner erwiesen, wenn die Nadelführungseinrichtung für die Transfernadeln zumindest eine erste und zweite Nadelführung aufweist, die im Axialabstand zu den Transfernadeln angeordnet sind. Dadurch lässt sich eine sehr präzise und exakte Führung der Transfernadeln auf ihrem Verstellweg realisieren, wobei bevorzugt die rückwärtige Mitnehmerplatte so weit verstellt werden kann, bis sie bei ihrer Verstellbewegung in Richtung Hybrid auf der rückwärtigen Seite der Nadelführungseinrichtung an einem dort vorgesehenen Anschlag, vorzugsweise auch an der rückwärtigen Nadelführung selbst, anschlägt.

Die Führungseinrichtung der Kontaktstifte ist bevorzugt in einer Ausführungsform der Erfindung so ausgebildet, dass darüber die Kontaktstifte fest und unverschiebbar dazu gehalten sind, so dass durch Axialverstellung der Führungseinrichtung die Kontaktstifte verstellt werden können.

Bevorzugt wird die Kontaktierbewegung mit einem Prüfling allein durch einen Hub des Nadelträgers für die Kontaktstifte realisiert, die nach dem Auftreffen auf das rückwärtige Ende mit Transfernadeln diese über einen entsprechenden Verstellweg mitnehmen und verstellen, bis deren vorlaufendes Ende an entsprechenden Kontaktpunkten auf dem Prüfling oder Hybrid auftrifft.

Bevorzugt kann die Verstellbewegungen der Kontaktstifte über Schubtraversen auf das Nadelbett übertragen werden. Der Antrieb kann dabei beispielsweise motorisch über eine Führungseinheit mit einer Spindel erfolgen.

Die Rückstellbewegung der Kontaktstifte kann beispielsweise durch eine federvorbelastete Einrichtung erfolgen, die auf die Mitnehmerplatte der Transfernadeln einwirkt. Möglich ist aber auch ein gesteuerter motorischer Antrieb, wobei, wie ausgeführt, die Kontaktstifte mit ihrer sie tragenden Führungseinrichtung weiter in ihre Ruhestellung zurückbewegt werden, so dass ein Isolierabstand zwischen den Kontaktstiften und den Transfernadeln entsteht, wenn sich die Nadeln nicht im Messzustand befinden.

In einer besonders bevorzugten Ausführungsform der Erfindung ist vorgesehen, dass die vorlaufende Stirnseite der Kontaktstifte oder die rückwärtige Seite der Transfernadeln mit einer Federkontakteinrichtung versehen ist. Bevorzugt werden die Kontaktstifte mit einer vorlaufenden Federeinrichtung versehen, weshalb sie auch nachfolgend teilweise als Federkontaktstifte bezeichnet werden.

Im Rahmen der Erfindung ist es möglich, für die Nadeln Durchmesser zu realisieren, die beispielsweise im Bereich einer Hülse eines Federkontaktstiftes einen Durchmesser von weniger als 1,5 mm, beispielsweise weniger als 1,3 mm und 1,1 mm aufweisen. Dadurch ist es auch möglich, einen Nadelabstand zu realisieren, der weniger als 1,3 mm beträgt.

Die Erfindung wird nachfolgend anhand von Zeichnungen näher erläutert. Dabei zeigen im Ausführungsbeispiel
- Figur 1:: eine schematische Schnittdarstellung durch eine erfindungsgemäße Kontaktierstation zum Testen von Prüflingen mit einer dar- unter befindlichen Kammer mit einem Aufla- ger und/oder einem Werkstückträger und darauf befindlichem Prüfling oder Hybrid;
- Figur 2:: eine schematische räumliche Darstellung der Kontaktierstation ohne darunter be- findliche Kammer mit Prüfling;
- Figur 3:: eine schematische Querschnittsdarstellung durch die erfindungsgemäße Kontaktiersta- tion;
- Figur 4:: eine schematische räumliche Darstellung eines Federkontaktstiftes, wie er auf ei- ner Transfernadel aufgelaufen ist;
- Figur 5:: eine Figur 3 entsprechende schematische Querschnittsdarstellung, jedoch bei auf einen Prüfling herabbewegten Kontaktstif- ten und Transfernadeln

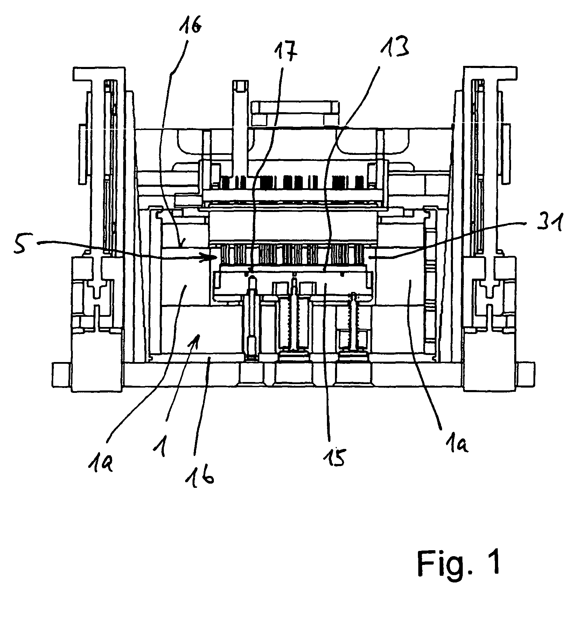

Nachfolgend wird auf Figur 1 Bezug genommen, die eine Kontaktierstation teilweise im schematischen Querschnitt wiedergibt.

Die Konaktierstation umfasst in ihrem unteren Teil eine nach außen hin abgeschlossene und isolierte Kammer 1 mit Seitenwänden 1a und einem Boden 1b. Auf der Oberseite ist die eigentliche Kontaktier- oder Messeinrichtung 5 vorgesehen (von der in Figur 1 in Schnittdarstellung ein Teil schematisch angedeutet ist), die üblicherweise ebenfalls wieder kammerartig gestaltet ist oder zumindest eine gegenüber dem Kammerinnenraum wirksame Abgrenzung oder Isolierung umfasst.

Im Kammerinnenraum 31 ist auf einem Auflager 17 eines Werkstückträgers 15 ein Prüfling oder Hybrid 13 positioniert und durch geeignete Maßnahmen fixiert (beispielsweise durch auf der Unterseite des Prüflings 13 wirksame und zum Prüfling hin offene Unterdruckkanäle, die über einen Unterdruck- und Vakuumkanal, der durch den Boden der Kammer 1 verläuft, mit einer externen Vakuumstation in Verbindung steht (die in den Zeichnungen nicht näher dargestellt ist)).

Der Prüfling 13 kann beispielsweise durch eine entsprechende Öffnung in die Kammer 1 hineingebracht und wieder hinaus befördert werden. Möglich ist aber auch, dass die Kammer 1 beispielsweise an ihrer oben liegenden Schnittstelle 16 eine Trennung aufweist, so dass sie seitlich längs der Schnittstelle 16 direkt unter die Kontaktier- und/oder Messeinrichtung 5 verfahren werden kann. In Figur 1 ist dabei schematisch angedeutet, wie ein zu überprüfender Prüfling 13 auf einem Auflager bzw. Werkstückträger 15 aufliegt.

Nachfolgend wird anhand der weiteren Darstellungen auf die eigentliche Kontaktier- und Messeinrichtung 5 mit einem zugehörigen Nadelfeld eingegangen.

In Figur 1 ist das Nadelfeld in der abgesenkten Messposition gezeigt.

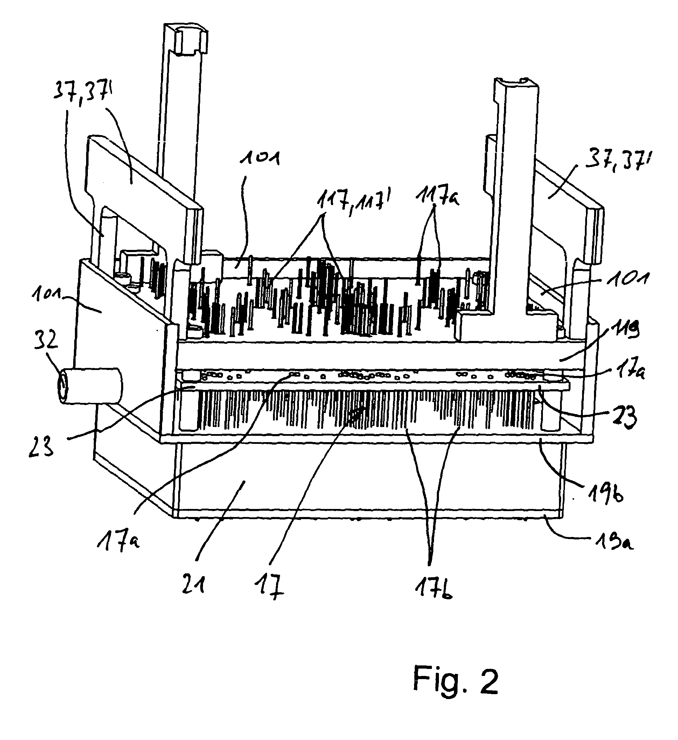

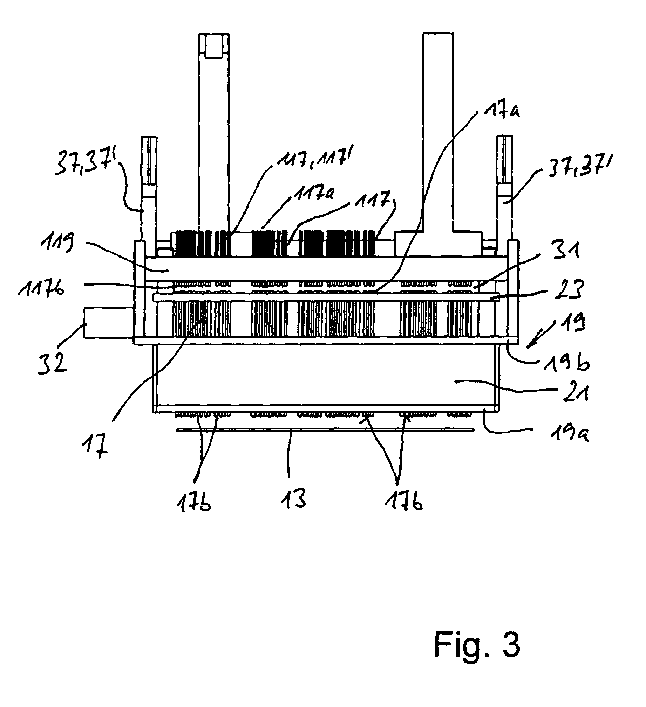

Die wesentlichen Teile der Konaktier- und/oder Messeinrichtung 5 sind in Figur 2 in einer schematischen räumlichen Darstellung und in Figur 3 in schematischer Seitenansicht in ihrer Ausgangs- oder Ruheposition (also vor dem eigentlichen Messvorgang) wiedergegeben.

Daraus ist ersichtlich, dass die eigentlichen Messnadeln (die im Stand der Technik durchgängig verlaufend ausgebildet sind) zweigeteilt sind und dem Prüfling oder Hybrid 13 näher liegende erste Nadeln umfassen, die nachfolgend auch als Transfernadeln 17 bezeichnet werden.

Diese Transfernadeln sind in einen Nadelträger 19 axial verschiebbar gehalten. Der Nadelträger 19 ist dabei relativ zur Kammer 1, d.h. relativ zum Prüfling 13 und/oder dem Auflager oder Werkstückträger unverschiebbar, also stationär, gehalten, d.h. unverschiebbar oder im Wesentlichen unverschiebbar bezüglich des axialen Verstellweges der Transfernadel 17 gehalten.

Um eine möglichst exakte Führung zu gewährleisten, weist ein zugehöriger Nadelträger 19 eine ausreichende Dicke quer, d.h. im gezeigten Ausführungsbeispiel senkrecht zum Prüfling 13 und damit parallel zur Axialerstreckung der Transfernadel 17 auf.

Der Nadelträger 19 umfasst dabei zwei im Axialabstand längs zu den Transfernadeln 17 beabstandet ausgebildete Nadelführungen 19a und 19b, in denen entsprechende Bohrungen zur Führung der Transfernadeln eingebracht sind.

Zwischen diesen beiden Nadelführungen 19a und 19b ist eine Isolierung 21 vorgesehen, um den Kammerinnenraum 3 auf der gewünschten vortemperierten Temperatur, beispielsweise bei 150°C oder -40°C zu halten, auf die auch der Prüfling 13 zuvor gebracht worden ist (im Übrigen weisen natürlich auch die Wände und der Boden der Kammer 1 entsprechende innenliegende und/oder außenliegende Isolierungen auf, die anhand von Figur 1 nicht separat erwähnt und gezeigt wurden).

An der dem Kammerinnenraum 31 und damit dem Prüfling 13 gegenüberliegenden rückwärtigen Seite des Nadelträgers 19 ist eine Mitnehmerplatte 23 vorgesehen, die von dem rückwärtigen Ende der Transfernadeln 17 durchsetzt wird und an der die Transfernadeln 17 mit ihrem rückwärtigen Ende 17a in einem geringen Maß vom Kammerinnenraum wegverlaufend überstehen.

Die Transfernadeln 17 sind axial unverschieblich oder nur gering verschieblich gegenüber der Mitnehmerplatte 23 gehalten. In der Ausgangs- oder Ruheposition (in der also keine Messung durchgeführt wird) können im gezeigten Ausführungsbeispiel die vorlaufenden Enden 17b der Transfernadeln 17 beispielsweise in einem bestimmten Maß über die dem Kammerinnenraum zugewandt liegenden Nadelträger 19 überstehen oder sogar innerhalb des Nadelträgers 19 zu liegen kommen, so dass sie nicht überstehen.

Wie insbesondere aus Figuren 2 und 3 auch hervorgeht, schließt sich am rückwärtigen Ende 17a der Transfernadeln 17 die davon getrennten, zusätzlich vorgesehenen Kontaktstifte 117 an, die im nachfolgenden teilweise auch als Federkontaktstifte 117' bezeichnet werden.

Diese Kontaktstifte 117 sind in einem weiteren Nadelträger 119 gehalten, und zwar axial unverschieblich.

Die rückwärtigen Enden 117a der Kontaktstifte 117 stehen über den Nadelträger 119 in ausreichendem Maße über. Von dort erfolgen dann nicht näher gezeigte Messabgriffe, die mit einer nachgeordneten Elektronik zur Auswertung der Messdaten während des Messvorgangs am Prüfling in Verbindung stehen.

Die über den Nadelträger 119 in Richtung Prüfling und damit in Richtung der Transfernadeln 17 überstehenden vorlaufenden Enden 117b stehen im gezeigten Ausführungsbeispiel bezogen auf die Gesamtlänge der Kontaktstifte nur in einem geringen Maße über, im gezeigten Ausführungsbeispiel für weniger als 20%, insbesondere weniger als 10% der Gesamtlänge der Kontaktstifte. Im Übrigen stehen auch die rückwärtigen Enden 117a der Transfernadeln 17 im gezeigten Ausführungsbeispiel weniger als 20%, insbesondere weniger als 10%, oder sogar weniger als 5% bezogen auf die Länge der Transfernadeln 17 über die Mitnehmerplatte 23 in Richtung der Kontaktstifte 117 über. Die vorlaufenden Spitzen der Kontaktstifte 117 enden exakt an jener Position, an der die rückwärtigen Enden der Transfernadeln 17 liegen. Im gezeigten Ausführungsbeispiel ist zudem der gesamte Raum zwischen dem Nadelträger 19 für die Transfernadeln und dem Nadelträger 119 für die Kontaktstifte über Gas und insbesondere über Luft spülbar, vorzugsweise über trockene Luft, wozu beispielsweise ein Einlassanschluss 32 und natürlich ein weiterer, im gezeigten Ausführungsbeispiel in den Figuren nicht näher dargestellter Auslass, vorgesehen ist. Die Anordnung kann aber derart sein, dass auch der zum Nadelträger 119 rückwärtige Bereich für die Trockenluftspülung mit erfasst wird. Schließlich ist der Gesamttrockenraum mit einer Schutzumhüllung 101 umgeben, die den Raum wandartig umschließt (in Figur 2 ist lediglich die vordere Wand dieser Schutzumhüllung 101 weggebrochen dargestellt).

Aufgrund des Aufbaus ergibt sich, dass die vorlaufenden Enden 17b der Transfernadeln, die in den Kammerinnenraum ragen und mit den Messstellen des Prüflings 13 während des Messvorganges in Kontakt treten, entsprechend der im Kammerinnenraum herrschenden Temperatur temperiert werden, beispielsweise stark erhitzt oder stark abgekühlt werden. Diese Temperaturbedingungen werden sich dann über die Länge der Transfernadeln (da sie elektrisch leitfähig sein müssen, und von daher auch die Temperatur gut übertragen) zu deren rückwärtigen Ende übertragen.

Da aber diese der Messung dienenden Transfernadeln 17 nicht einstückig bis zur eigentlichen Messauswertung oder Messverdrahtung durchgeführt sind, sondern eine anhand von Figur 2 und 3 ersichtliche Unterbrechung, also einen sogenannten Isolierabstand 35, zueinander aufweisen, kann sich diese Temperatur nicht auf die mit der Messverdrahtung in Verbindung stehenden Kontaktstifte 117 übertragen. Durch diesen, eine Temperaturbrücke vermeidenden Isolierabstand 35 kann also ein entsprechender Temperaturtransport zur Messverdrahtung sicher unterbunden werden. Da auch der Raum zwischen den Kontaktstiften 117 und den Transfernadeln 17 wie erwähnt beispielsweise mit Trockenluft umspült werden kann, wird zudem eine Betauung auch in diesem Raum sicher vermieden.

Um einen Messvorgang ausgehend von der Außer-Eingriffs- oder Ruheposition entsprechend Figur 2 oder 3 durchzuführen, sind im gezeigten Ausführungsbeispiel noch zwei gegenüberliegende Schubeinrichtungen 37 vorgesehen, die auch nachfolgend teilweise als Schubtraversen 37' bezeichnet werden. Sie sind an den gegenüberliegenden Seiten des Nadelträgers 119 für die Kontaktstifte 117 vorgesehen. Eine Kontaktierbewegung zur Einleitung eines Messvorganges wird über eine nicht näher dargestellte Antriebseinrichtung dadurch bewirkt, dass von dieser nicht näher wiedergegebenen Antriebseinrichtung die Schubtraversen in Richtung Kammer 1, also in Richtung Prüfling oder Hybrid 13, vorwärts bewegt werden. Diese Hubbewegung kann beispielsweise Maß von 15 bis 20 mm oder dergleichen aufweisen.

Durch diese Bewegung des Nadelträgers 119 laufen dann während der Schub- oder Hubbewegung die vorlaufenden Spitzen oder Enden 117a der Kontaktstifte 117 auf das rückwärtige Ende 17a der Transfernadeln 17 auf und nehmen somit die Transfernadeln in Richtung Kontaktpunkte auf den zu überprüfenden Prüfling oder Hybrid 13 mit. Da zwischen den vorlaufenden Enden 17b der Kontaktstifte 117 und den rückwärtigen Enden 17a der Transfernadeln 17 in der Ausgangs- oder Ruheposition ein Abstand, nämlich der sogenannte Isolierabstand 37, besteht, muss dieser Abstand beispielsweise in einer Höhe von 2 bis 4 mm zunächst durch die Hubbewegung der Kontaktstifte 117 überwunden werden, bis dann die Kontaktstifte 117 die Transfernadeln 117 über den verbleibenden Schub- oder Hubweg mitnehmen.

Durch die Zweipunktführung der Transfernadeln 17, die durch die entsprechenden Bohrungen in den im Axialabstand zueinander positionierten Nadelführungen 19a und 19b sichergestellt ist, lässt sich eine maximale Auslenkung an der Spitze der Transfernadeln so begrenzen, dass diese Auslenkung nur einen Bruchteil der Bohrungsgenauigkeit der Lochbohrungen für die Führung der Transfernadeln darstellt.

Die Kontaktierkraft wird mittels der Schubtraversen auf das Nadelbett oder Nadelfeld mit den Kontaktstiften 117 übertragen, wobei der Antrieb bevorzugt motorisch über Führungseinheiten mittels einer Spindel erfolgen kann.

Um sicherzustellen, dass die vorlaufenden Spitzen der Transfernadeln 17 exakt und unter ausreichender Kraft an den Messpunkten eines Prüflings oder Hybrids 13 anliegen (und dabei sicherstellen, dass an den Kontakt- oder Lötpunkten des Prüflings die Transfernadeln unter Umständen relativ zueinander unterschiedlich weit vorbewegt werden müssen), ist im gezeigten Ausführungsbeispiel die vorlaufende Spitze 117a der Kontaktstifte mit einer Federeinrichtung, einer sogenannten Federspitze 39, versehen, die eine ausreichende relative Verschiebbarkeit dieser nadelförmigen Federspitze 39 gegenüber dem jeweiligen Kontaktstift 117 erlaubt. Dabei ist ferner zu berücksichtigen, dass die Transfernadeln 17 in der zugehörigen Mitnehmerplatte 23 zumindest geringfügig relativ verstellbar sind. Durch diese Anordnung wird gewährleistet, dass beim Aufsetzen der vorlaufenden Spitzen der Kontaktstifte 117 am rückwärtigen Ende der Transfernadeln (die mit der Mitnehmerplatte gemeinsam in Richtung Prüfling/Hybrid 13 in das Kammerinnere 31 hineinbewegt werden) die vorlaufenden Spitzen der Transfernadeln 17 in unterschiedlicher Höhenlage an den einzelnen Messpunkten am Prüfling/Hybrid 13 auftreffen können, also einige Transfernadeln von daher in ihrer Axialbewegung früher stoppen als andere. Die Transfernadeln, deren Axialbewegung früher endet, müssen von daher eine gewisse Relativverschiebung gegenüber ihrer Mitnehmerplatte 23 durchführen können. Von daher sind die Transfernadeln 17 in der Mitnehmerplatte 23 so gehalten, dass beim Auflaufen einer Transfernadel 17 an einem Messpunkt auf dem Prüfling (unter Vorwärtsbewegung der betreffenden Transfernadel) die Mitnehmerplatte 23 und noch andere Transfernadeln um einen gewissen Hub weiter in Axialrichtung verstellt werden können. Mit anderen Worten wird das rückwärtige Ende einer vorher auflaufenden Transfernadel entgegen der Kraft einer Reibwirkung über ein gewisses Maß relativ gegenüber der Mitnehmerplatte verstellt. Diese relative Verstellmöglichkeit ist also zwischen einem Kontaktstift 17 und der Mitnehmerplatte 23 vorgesehen. Durch das frühzeitige Auflaufen einiger Transfernadeln auf einen Messpunkt gegenüber anderen, muss dann aber auch ein Ausgleich bezüglich der Kontaktstifte möglich sein. Von daher werden, wie im Rahmen der Erfindung beschrieben, sogenannte Kontaktfederstifte 117' verwendet, wobei die vorlaufende Federspitze 39 entgegen der Kraft einer Feder um ein gewisses Axialmaß gegenüber dem verbleibenden Federstift 117 eingefahren wird, um hier die Ausgleichsbewegung zu ermöglichen.

Umgekehrt kann natürlich eine derartige Federspitze 39 oder Federeinrichtung 39 allgemein auch an einer jeweiligen Transfernadel 17, vorzugsweise am rückwärtigen Ende oder aber auch beispielsweise am vorlaufenden Ende der Transfernadel 17, vorgesehen sein.

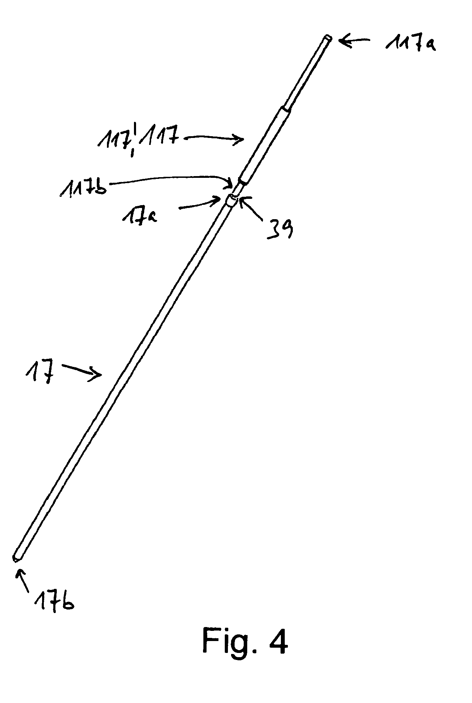

Anhand von Figur 4 ist eine Anordnung eines rückwärtigen Kontaktstiftes 17 mit vorlaufender Federspitze 39 und der sich axial daran anschließenden Transfernadel gezeigt.

Der Durchmesser eines Nadelsatzes kann beispielsweise um 1 mm betragen. Die axial verstellbare stapelförmige Federspitze 39 weist demgegenüber einen nochmals geringeren Außendurchmesser auf und ist im gezeigten Ausführungsbeispiel am vorlaufenden Ende 117b eines Kontaktstiftes 17 axial in diesen ein- und ausschiebbar, und zwar durch eine integrierte Federanordnung in maximaler Ausfahrrichtung vorgespannt.

Das rückwärtige Ende 17b der Transfernadel 17 kann hier einen Ansatz mit etwas größerem Außendurchmesser als den verbleibenden Außendurchmesser der Transfernadel aufweisen, gegebenenfalls mit einer rückwärtigen, über ein geringes Axialmaß ausgebildeten Bohrung, in welcher die vorlaufende Federspitze 39 beim Auflaufen der Kontaktstifte auf die Transfernadeln eingreifen kann, wodurch auch eine gute elektrische Messverbindung der elektrisch leitfähigen, d.h. aus einer Metalllegierung bestehenden, Rasiernadeln und Kontaktstifte.

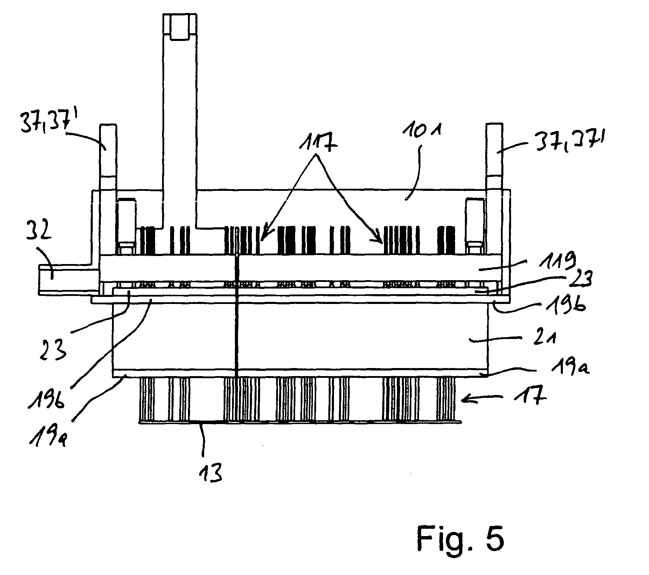

Während in Figur 2 und 3 die Anordnung der Lage der Kontaktstifte 117 und der Transfernadeln 17 in ihrer Ausgangslage (in der keine Messung durchgeführt wird) gezeigt ist, gibt Figur 5 die Situation dann wieder, wenn unter Betätigung der Schubtraversen 37' über die nicht näher gezeigte Antriebseinrichtung zunächst die Federkontaktstifte 117' und dann nach Überwindung des Isolierabstands 35 mit diesen auch die Transfernadeln 17 auf einen Prüfling 13 herabbewegt worden sind.

Das Ausführungsbeispiel ist für jene Fälle erläutert worden, dass die Kontaktstifte oder Federkontaktstifte in axialer Verlängerung der betreffenden, parallel zueinander angeordneten Transfernadeln verlaufen.

Wenn die Transfernadeln in besonderen EInsatzfällen sehr dicht zueinander angeordnet sind, ist es aber auch möglich, dass beispielsweise die dahinter angeordneten Kontakt- oder Federkontaktstifte von der Mitte des Nadelfeldes aus nach außen zunehmend stärker zu ihrem rückwärtigen Ende divergierend verlaufen, um an ihrem rückwärtigen Ende mehr Platz für einen Messabgriff zu haben. In diesem Fall wäre nur sicherzustellen, dass die vorlaufenden Spitzen der Kontaktstifte genau dort enden, wo das rückwärtige Ende der Transfernadeln liegt. In diesem Falle würden dann bevorzugt die Federspitzen 39 entweder am Ende oder an dem dem Prüfling zugewandt liegenden vorlaufenden Ende der Transfernadeln ausgebildet sein.

## Patentansprüche

1. Kontaktierstation zum Testen von Prüflingen (13) unter Temperatur, mit folgenden Merkmalen:
- einer Kammer (1),
- im Kammerinnenraum (31) ist vorzugsweise auf einem Auflager und/oder einem Werkstückträger (9, 10) ein zu testender Prüfling (13) plazierbar,
- relativ zum Auflager und/oder Werkstückträger (9, 10) versetzt liegend ist eine Kontaktier- und Messeinrichtung (5) vorgesehen, welche ein Nadelfeld mit einer Vielzahl von Kontakt- und/oder Messnadeln umfasst, die in einer Axialrichtung zwischen einer Mess- und einer Außer-Eingriffs-Position verstellbar sind,
**gekennzeichnet durch** folgende weiteren Merkmale:
- die Kontakt- und/oder Messnadeln sind zumindest zweigeteilt und umfassen dem Auflager und/oder Werkstückträger (9, 10) näher liegende Transfernadeln (17), an deren rückwärtigem Ende (17a) sich separate Kontaktstifte (117) anschließen,
- zur Durchführung eines Messvorganges an einem Prüfling (13) sind die Kontaktstifte (117) und die Transfernadeln (17) so verstellbar, dass ein Kontaktstift (117) mit einer ihm zugeordneten Transfernadel (17) mechanisch und elektrisch kontaktiert ist, und
- die Transfernadeln (17) und die Kontaktstifte (117) sind in gegenüber einer Messposition in eine Ausgangs- und Ruheposition verfahrbar, in der die Kontaktstifte (117) unter Ausbildung eines Isolierabstandes (35) versetzt zu den Transfernadeln (17) liegen.

2. Kontaktierstation nach Anspruch 1, **dadurch gekennzeichnet, dass** während des Messvorganges an einem Prüfling (13) das vorlaufende Ende (117b) eines Kontaktstiftes (117) mit dem rückwärtigen Ende (17a) einer ihm zugeordneten Transfernadel (17) in Kontakt steht.

3. Kontaktierstation nach Anspruch 2, **dadurch gekennzeichnet, dass** das vorlaufende Ende (117b) eines Kontaktstiftes (117) und/oder das rückwärtige Ende (17a) einer Transfernadel (17) und/oder das vorlaufenden Ende (17b) einer Transfernadel (17) mit einer Federspitze (39) versehen ist, die entgegen der Kraft einer Federeinrichtung relativ verstellbar ist, insbesondere entgegen der Kraft einer Feder unter Verkürzung der gesamten Länge des Kontaktstiftes (117) bzw. der Transfernadel (17) verstellbar ist.

4. Kontaktierstation nach einem der Ansprüche 1 bis 3, **dadurch gekennzeichnet, dass** die Transfernadeln (17) parallel zueinander angeordnet sind und vorzugsweise in Axialrichtung zwischen einer Mess- und einer Ruhe- oder Außer-Eingriffs-Position mit dem Prüfling (13) verstellbar sind.

5. Kontaktierstation nach einem der Ansprüche 1 bis 4, **dadurch gekennzeichnet, dass** die Kontaktstifte (117) parallel zueinander und vorzugsweise parallel zu den Transfernadeln (17) angeordnet und/oder verstellbar sind.

6. Kontaktierstation nach einem der Ansprüche 1 bis 4, **dadurch gekennzeichnet, dass** die Kontaktstifte (117) nicht parallel oder überwiegend nicht parallel, sondern divergierend oder überwiegend divergierend zueinander verlaufend angeordnet sind, derart, dass die Kontaktstifte (117) auf ihrem rückwärtigen Ende (117a) einen größeren Relativabstand zueinander aufweisen, als der Abstand zwischen ihren vorlaufenden Enden (117b).

7. Kontaktierstation nach einem der Ansprüche 1 bis 6, **dadurch gekennzeichnet, dass** die Transfernadeln (17) in einem Nadelträger (19) axial zu diesem verstellbar geführt sind.

8. Kontaktierstation nach Anspruch 7, **dadurch gekennzeichnet, dass** der Nadelträger (19) eine axiale Erstreckung parallel zu einer jeweiligen Transfernadel (17) aufweist, die mehr als 30%, insbesondere mehr als 40%, 50%, 60% oder 70% der Gesamtlänge einer Transfernadel (17) entspricht.

9. Kontaktierstation nach Anspruch 7 oder 8, **dadurch gekennzeichnet, dass** der Nadelträger (19) zwei in Axialrichtung der Transfernadeln (17) beabstandete Nadelführungen (19a, 19b) aufweist.

10. Kontaktierstation nach Anspruch 9, **dadurch gekennzeichnet, dass** zwischen den beiden Nadelführungen (19a, 19b) eine Isolierung (21) angeordnet ist.

11. Kontaktierstation nach einem der Ansprüche 1 bis 10, **dadurch gekennzeichnet, dass** die Transfernadeln (17) zusätzlich über eine Mitnehmerplatte (23) gehalten sind, vorzugsweise im Bereich des rückwärtigen Endes (17a) der Transfernadeln (17).

12. Kontaktierstation nach Anspruch 11, **dadurch gekennzeichnet, dass** die Transfernadeln (17) an ihrem rückwärtigen Ende (17a) nur um ein geringes Maß über die Mitnehmerplatte (23) überstehen, vorzugsweise mit weniger als 20%, insbesondere weniger als 10% oder weniger als 5% der Gesamtlänge der Transfernadeln (17).

13. Kontaktierstation nach Anspruch 11 oder 12, **dadurch gekennzeichnet, dass** die Transfernadeln (17) mit der Mitnehmerplatte (23) mitbewegbar sind, wobei einzelne Transfernadeln (17) relativ zur Mitnehmerplatte (23) unter Überwindung einer Haltereibung axial verstellbar sind.

14. Kontaktierstation nach einem der Ansprüche 1 bis 13, **dadurch gekennzeichnet, dass** die Kontaktstifte (117) über einen Nadelträger (119) gehalten und verstellbar sind.

15. Kontaktierstation nach Anspruch 14, **dadurch gekennzeichnet, dass** der Nadelträger (119) eine axiale Dicke und/oder Länge und/oder einen axialen Abstand zwischen zwei versetzt zueinander liegenden Nadelträgerabschnitten aufweist, wobei dieses Maß mehr als 20%, vorzugsweise mehr als 30% oder 40% der Gesamtlänge der Kontaktstifte (117) beträgt.

16. Kontaktierstation nach Anspruch 14 oder 15, **dadurch gekennzeichnet, dass** die Kontaktstifte (117) in dem Nadelträger (119) axial unverschieblich gehalten sind.

17. Kontaktierstation nach einem der Ansprüche 14 bis 16, **dadurch gekennzeichnet, dass** das vorlaufende Ende (117b) der Kontaktstifte (117) um weniger als 30%, vorzugsweise weniger als 20% und weniger als 10% oder 5% der Gesamtlänge der Kontaktstifte (117) über den Nadelträger (119) überstehen.

18. Kontaktierstation nach einem der Ansprüche 1 bis 17, **dadurch gekennzeichnet, dass** über eine Antriebseinrichtung vorzugsweise in Form einer Schubeinrichtung (37) oder einer Schubtraverse (37') der Nadelträger (119) und darüber die Kontaktstifte (117) zwischen einer Messposition und einer rückwärtigen Ruhe- oder Außer-Eingriffs-Position verstellbar sind, wobei beim Auflaufen der vorlaufenden Enden (117b) der Kontaktstifte (117) auf den rückwärtigen Enden (117a) der Transfernadeln (17) diese in ihre Messposition unter Kontaktierung von Messstellen auf einem Prüfling (13) verstellbar sind.

19. Kontaktierstation nach einem der Ansprüche 1 bis 18, **dadurch gekennzeichnet, dass** die mit der Mitnehmerplatte (23) mit verstellbaren Transfernadeln (17) durch eine Antriebseinrichtung und/oder eine Federeinrichtung bei Rückwärtsbewegung der Kontaktstifte (117) in ihre Ruheposition bis zu einer vom Prüfling (13) entfernt liegenden Ausgangsposition verstellbar sind.

20. Kontaktierstation nach einem der Ansprüche 1 bis 19, **dadurch gekennzeichnet, dass** in der Ruhe- oder Ausgangsposition zwischen den vorlaufenden Enden (117b) der Kontaktstifte (117) und den rückwärtigen Enden (117a) der Transfernadeln (17) ein Isolierabstand (25) besteht.

21. Kontaktierstation nach einem der Ansprüche 1 bis 20, **dadurch gekennzeichnet, dass** der Raum im Bereich der rückwärtigen Enden (117a) der Transfernadeln (17) und der vorlaufenden Enden (117b) der Kontaktstifte (117) mittels eines Gases, insbesondere mittels Luft, vorzugsweise mittels Trockenluft, spülbar ist.

22. Kontaktierstation nach Anspruch 21, **dadurch gekennzeichnet, dass** der Raum oberhalb des Nadelträgers (19) der Transfernadeln (17) und unterhalb des Nadelträgers (119) der Kontaktstifte (117) mittels Gas, Luft, und insbesondere Trockenluft, spülbar ist.

23. Kontaktierstation nach Anspruch 21 oder 22, **dadurch gekennzeichnet, dass** zusätzlich auch der Raum oberhalb des Nadelträgers (119) der Kontaktstifte (117) mittels eines Gases, Luft, uns insbesondere Trockenluft, spülbar ist.

24. Kontaktierstation nach einem der Ansprüche 1 bis 23, **dadurch gekennzeichnet, dass** zwischen der Kammer (1) mit den darin befindlichen Auflager- und/oder Werkstückträgern (9, 10) und einem darauf positionierbaren Prüfling (13) und dem eigentlichen Kontaktierfeld einschließlich der Kontaktstifte (117) und Transfernadeln (17) eine Schnittebene (15) ausgebildet ist, längs der die Kammer (1) mit dem darin befindlichen Prüfling (13) zum Nadelfeld verfahr- und davon nach Durchführung der Messsung wegverfahrbar ist.

## Claims

1. Contacting station for testing test items (13) under temperature, having the following features:
- a chamber (1)
- a test item (13) to be tested can preferably be positioned in the chamber interior (31) on a support and/or workpiece carrier (9, 10),
- a contacting and measurement means (5) is provided positioned offset relative to the support and/or workpiece carrier (9, 10) and comprises a needle bed having a number of contact and/or measurement needles which can be adjusted in an axial direction between a measurement position and a disengaged position,
**characterised by** the following further features:
- the contact and/or measurement needles are divided at least in two and comprise transfer needles (17) which are positioned relatively close to the support and/or workpiece carrier (9, 10) and to the rear end (17a) of which separate contact pins (117) are attached,
- for carrying out a measurement process on a test item (13), the contact pins (117) and the transfer needles (17) can be adjusted in such a way that a contact pin (117) is mechanically and electrically contacted with a transfer needle (17) associated therewith, and
- the transfer needles (17) and the contact pins (117) are displaceable into an initial or idle position, in which the contact pins (117) are positioned offset from the transfer needles (17) to produce an insulating gap (35), as opposed to a measurement position.

2. Contacting station according to claim 1, **characterised in that** during the measurement process on a test item (13), the front end (117b) of a contact pin (117) is in contact with the rear end (17a) of a transfer needle (17) associated therewith.

3. Contacting station according to claim 2, **characterised in that** the front end (117b) of a contact pin (117) and/or the rear end (17a) of a transfer needle (17) and/or the front end (17b) of a transfer needle (17) is provided with a spring tip (39) which can undergo a relative adjustment against the force of a spring means, in particular which can be adjusted against the force of a spring so as to shorten the total length of the contact pin (117) or transfer needle (17).

4. Contacting station according to any one of claims 1 to 3, **characterised in that** the transfer needles (17) are arranged mutually parallel and are preferably adjustable in the axial direction between a measurement position and an idle or disengaged position with the test item (13).

5. Contacting station according to any one of claims 1 to 4, **characterised in that** the contact pins (117) are arranged and/or adjustable parallel to one another and preferably parallel to the transfer needles (17).

6. Contacting station according to any one of claims 1 to 4, **characterised in that** the contact pins (117) are non-parallel or predominantly non-parallel, and are arranged extending divergently or predominantly divergently with respect to one another, in such a way that the contact pins (117) have a relative distance from one another at the rear ends (117a) thereof greater than the distance between the front ends (117b) thereof.

7. Contacting station according to any one of claims 1 to 6, **characterised in that** the transfer needles (17) are guided in a needle carrier (19) so as to be adjustable axially with respect thereto.

8. Contacting station according to claim 7, **characterised in that** the needle carrier (19) has an axial extension, parallel to a respective transfer needle (17), which corresponds to more than 30 %, in particular more than 40 %, 50 %, 60 % or 70 %, of the total length of a transfer needle (17).

9. Contacting station according to either claim 7 or claim 8, **characterised in that** the needle support (19) comprises two needle guides (19a, 19b) which are spaced apart in the axial direction of the transfer needles (17).

10. Contacting station according to claim 9, **characterised in that** insulation (21) is arranged between the two needle guides (19a, 19b).

11. Contacting station according to any one of claims 1 to 10, **characterised in that** the transfer needles (17) are additionally held by means of a drive plate (23), preferably in the region of the rear end (17a) of the transfer needles (17).

12. Contacting station according to claim 11, **characterised in that** the transfer needles (17) only project over the drive plate (23) by a small amount at the rear ends (17a) thereof, preferably by less than 20 %, in particular less than 10 % or less than 5 %, of the total length of the transfer needles (17).

13. Contacting station according to either claim 11 or claim 12, **characterised in that** the transfer needles (17) can be moved together with the drive plate (23), individual transfer needles (17) being adjustable axially with respect to the drive plate (23) by overcoming retaining friction.

14. Contacting station according to any one of claims 1 to 13, **characterised in that** the contact pins (117) are held and are adjustable by means of a needle carrier (119).

15. Contacting station according to claim 14, **characterised in that** the needle carrier (119) has an axial thickness and/or length and/or an axial distance between two needle carrier portions positioned mutually offset, this measurement being more than 20 %, preferably more than 30 % or 40 %, of the total length of the contact pins (117).

16. Contacting station according to either claim 14 or claim 15, **characterised in that** the contact pins (117) are held so as to be axially non-displaceable in the needle carrier (119).

17. Contacting station according to any one of claims 14 to 16, **characterised in that** the front end (117b) of the contact pins (117) projects beyond the needle carrier (119) by less than 30 %, preferably less than 20 % and less than 10 % or 5 %, of the total length of the contact pins (117).

18. Contacting station according to any one of claims 1 to 17, **characterised in that** the needle carrier (119), and thus the contact pins (117), can be adjusted between a measurement position and a rearward idle or disengaged position by means of a drive means, preferably in the form of a sliding means (37) or sliding rail (37'), it being possible, when the front ends (117b) of the contact pins (117) strike the rear ends (117a) of the transfer needles (16), to adjust said needles into the measurement position thereof so as to contact measurement points on a test item (13).

19. Contacting station according to any one of claims 1 to 18, **characterised in that** the transfer needles (17) which can be adjusted together with the drive plate (23) can be adjusted into an initial position remote from the test item (13) by a drive means and/or a spring means when the contact pins (117) move rearwards into the idle position thereof.

20. Contacting station according to any one of claims 1 to 19, **characterised in that** there is an insulation gap (25) between the front ends (117b) of the contact pins (117) and the rear ends (117a) of the transfer needles (17) in the initial or idle position.

21. Contacting station according to any one of claims 1 to 20, **characterised in that** the space in the region of the rear ends (117a) of the transfer needles (17) and the front ends (117b) of the contact pins (117) can be rinsed using a gas, in particular using air, in particular using dry air.

22. Contacting station according to claim 21, **characterised in that** the space above the needle carrier (19) of the transfer needles (17) and below the needle carrier (119) of the contact pins (117) can be rinsed using gas, air, and in particular dry air.

23. Contacting station according to either claim 21 or claim 22, **characterised in that** additionally, the space above the needle carrier (119) of the contact pins (117) can be rinsed using a gas, air, and in particular dry air.

24. Contacting station according to any one of claims 1 to 23, **characterised in that** a cutting plane (15), along which the chamber (1) with the test item (13) located therein is displaceable relative to the needle bed and away therefrom after the measurement is carried out, is formed between the chamber (1), having located therein the support and/or workpiece carriers (9, 10) and a test item (13) which can be positioned thereon, and the actual contacting field containing the contact pins (117) and transfer needles (17).

## Revendications

1. Poste de contact pour tester des échantillons (13) sous température, présentant les éléments suivants :
- une chambre (1),
- un échantillon (13) à tester est susceptible d'être placé dans l'espace intérieur de la chambre (31), de préférence sur un support et/ou un porte-pièce (9, 10),
- un dispositif de mise en contact et de mesure (5) est prévu, disposé en décalage par rapport au support et/ou au porte-pièce (9, 10), ce dispositif comprenant un champ d'aiguilles avec une pluralité d'aiguilles de contact et/ou de mesure, qui sont déplaçables en direction axiale entre une position de mesure et une position hors d'engagement,
**caractérisé par** les autres éléments suivants :
- les aiguilles de contact et/ou de mesure sont réalisées au moins en deux parties et comprennent des aiguilles de transfert (17), situées plus proche du support et/ou du porte-pièce (9, 10), à l'extrémité postérieure desquelles (17a) font suite des tiges de contact séparées (117),
- pour l'exécution d'une opération de mesure sur un échantillon (13), les tiges de contact (117) et les aiguilles de transfert (17) sont déplaçables de telle manière qu'une tige de contact (117) vient en contact mécanique et électrique avec une aiguille de transfert (17) qui lui est associée, et
- les aiguilles de transfert (17) et les tiges de contact (117) sont déplaçables, par rapport à une position de mesure, jusque dans une position de départ et de repos dans laquelle les tiges de contact (117) se trouvent en décalage par rapport aux aiguilles de transfert (17) en formant une distance d'isolation (35).

2. Poste de contact selon la revendication 1, **caractérisé en ce que,** pendant l'opération de mesure sur un échantillon (13), l'extrémité antérieure (117b) d'une tige de contact (117) est en contact avec l'extrémité postérieure (17a) d'une aiguille de transfert (17) qui lui est associée.

3. Poste de contact selon la revendication 2, **caractérisé en ce que** l'extrémité antérieure (117b) d'une tige de contact (117) et/ou l'extrémité postérieure (17a) d'une aiguille de transfert (17) et/ou l'extrémité antérieure (17b) d'une aiguille de transfert (17) est pourvue d'une pointe à ressort (39), laquelle est déplaçable à l'encontre de la force d'un dispositif à ressort, en particulier à l'encontre de la force d'un ressort avec raccourcissement de la longueur totale de la tige de contact (117) ou de l'aiguille de transfert (17).

4. Poste de contact selon l'une des revendications 1 à 3, **caractérisé en ce que** les aiguilles de transfert (17) sont agencées parallèlement les unes aux autres et sont déplaçables, de préférence déplaçables en direction axiale, entre une position de mesure et une position de repos, ou position hors d'engagement, avec l'échantillon (13).

5. Poste de contact selon l'une des revendications 1 à 4, **caractérisé en ce que** les tiges de contact (117) sont agencées et/ou déplaçables parallèlement les unes aux autres et de préférence parallèlement aux aiguilles de transfert (17).

6. Poste de contact selon l'une des revendications 1 à 4, **caractérisé en ce que** les tiges de contact (117) sont agencées de manière à s'étendre non pas parallèlement ou majoritairement pas parallèlement, mais de façon divergente ou majoritairement divergente les unes par rapport aux autres, de telle façon que les tiges de contact (117) présentent à leur extrémité postérieure (117a), une distance relative les unes par rapport aux autres plus importante que la distance entre leurs extrémités antérieures (117b).

7. Poste de contact selon l'une des revendications 1 à 6, **caractérisé en ce que** les aiguilles de transfert (17) sont guidées dans un porte-aiguilles (19) de façon déplaçable axialement par rapport à celui-ci.

8. Poste de contact selon la revendication 7, **caractérisé en ce que** le porte-aiguilles (19) présente, parallèlement à une aiguille de transfert respective (17), une extension axiale qui correspond à plus de 30 %, en particulier plus de 40 %, 50 %, 60 % ou 70 % de la longueur totale d'une aiguille de transfert (17).

9. Poste de contact selon la revendication 7 ou 8, **caractérisé en ce que** le porte-aiguilles (19) comprend de guidage d'aiguilles (19a, 19b) écarté en direction axiale des aiguilles de transfert (17).

10. Poste de contact selon la revendication 9, **caractérisé en ce qu'**une isolation (21) est agencée entre les deux guidages d'aiguilles (19a, 19b).

11. Poste de contact selon l'une des revendications 1 à 10, **caractérisé en ce que** les aiguilles de transfert (17) sont maintenues additionnellement via une plaque d'entraînement (17), de préférence dans la région de l'extrémité postérieure (17a) des aiguilles de transfert (17).

12. Poste de contact selon la revendication 11, **caractérisé en ce que** les aiguilles de transfert (17) dépassent, à leur extrémité postérieure (17a), au-delà de la plaque d'entraînement (23), seulement d'une petite dimension, de préférence sur moins de 20 %, en particulier moins de 10 %, ou moins de 5 % de la longueur totale des aiguilles de transfert (17)

13. Poste de contact selon la revendication 11 ou 12, **caractérisé en ce que** les aiguilles de transfert (17) sont déplaçables conjointement avec la plaque d'entraînement (23), et des aiguilles de transfert individuelles (17) sont déplaçables axialement par rapport à la plaque d'entraînement (23) en surmontant une friction de retenue.

14. Poste de contact selon l'une des revendications 1 à 13, **caractérisé en ce que** les tiges de contact (117) sont maintenues et déplaçables via un porte-aiguilles (119).

15. Poste de contact selon la revendication 14, **caractérisé en ce que** le porte-aiguilles (119) présentent une épaisseur axiale et/ou une longueur et/ou une distance axiale entre deux tronçons de porte-aiguilles agencés en décalage l'un par rapport à l'autre, ladite dimension étant plus de 20 %, de préférence plus de 30 % ou 40 % de la longueur totale des tiges de contact (117).

16. Poste de contact selon la revendication 14 ou 15, **caractérisé en ce que** les tiges de contact (117) sont maintenues sans possibilité de déplacement axial dans le porte-aiguilles (119).

17. Poste de contact selon l'une des revendications 14 à 16, **caractérisé en ce que** l'extrémité antérieure (117b) des tiges de contact (117) dépasse au-delà du porte-aiguille (119) sur moins de 30 %, de préférence moins de 20 %, et moins de 10 % ou 5 % de la longueur totale des tiges de contact (117).

18. Poste de contact selon l'une des revendications 1 à 17, **caractérisé en ce que** le porte-aiguilles (119) et, via celui-ci, les tiges de contact (117) sont déplaçables via un dispositif d'entraînement, de préférence sous la forme d'un dispositif de poussée (37) ou d'une traverse de poussée (37'), entre une position de mesure et une position de repos ou position hors d'engagement postérieure, et lors de l'arrivée des extrémités antérieures (117b) des tiges de contact (117) sur les extrémités postérieures (117a) des aiguilles de transfert (17) celles-ci sont déplaçables jusque dans leur position de mesure avec venue en contact de points de mesure sur un échantillon (13).

19. Poste de contact selon l'une des revendications 1 à 18, **caractérisé en ce que** les aiguilles de transfert (17) déplaçables conjointement avec la plaque d'entraînement (23), sont déplaçables par un dispositif d'entraînement et/ou par un dispositif à ressort lors du mouvement de recul des tiges de contact (117) jusque dans leur position de repos jusqu'à une position de départ située en éloignement de l'échantillon (13).

20. Poste de contact selon l'une des revendications 1 à 19, **caractérisé en ce qu'**il est prévu une distance d'isolation (25) dans la position de repos ou position de départ, entre les extrémités antérieures (117b) les tiges de contact (117) et les extrémités postérieures (117a) des aiguilles de transfert (17).

21. Poste de contact selon l'une des revendications 1 à 20, **caractérisé en ce que** l'espace dans la région des extrémités postérieures (117a) des aiguilles de transfert (17) et les extrémités antérieures (117b) des tiges de contact (117) est susceptible d'être rincé au moyen d'un gaz, en particulier au moyen d'air, de préférence au moyen d'air sec.

22. Poste de contact selon la revendication 21, **caractérisé en ce que** l'espace au-dessus du porte-aiguilles (19) des aiguilles de transfert (17) et au-dessous du porte-aiguilles (119) des tiges de contact (117) est susceptible d'être rincé au moyen d'un gaz, d'air, et en particulier d'air sec.

23. Poste de contact selon la revendication 21 ou 22, **caractérisé en ce que**, additionnellement, également l'espace au-dessus du porte-aiguilles (119) des tiges de contact (117) est susceptible d'être rincé au moyen d'un gaz, d'air, et en particulier d'air sec.

24. Poste de contact selon l'une des revendications 1 à 23, **caractérisé en ce que**, entre la chambre (1) avec les supports et/ou les portes-pièces (9, 10) qui se trouvent dans celle-ci et un échantillon (13) susceptible d'être positionné sur ceux-ci, et le champ de contacts proprement dit, y compris les tiges de contact (117) et les aiguilles de transfert (17), est réalisé un plan de coupe (15), le long duquel la chambre (1) avec l'échantillon (13) qui se trouve dans celle-ci est déplaçable vers le champ d'aiguilles, et déplaçable en éloignement de celui-ci après exécution de la mesure.
